(19) Europäisches Patentamt
European Patent Office
Office européen des brevets

(11) **EP 4 580 381 B1**

(12) **EUROPEAN PATENT SPECIFICATION**

(45) Date of publication and mention
of the grant of the patent:
**15.07.2026 Bulletin 2026/29**

(21) Application number: **24216840.9**

(22) Date of filing: **02.12.2024**

(51) International Patent Classification (IPC):
*H10N 30/076* (2023.01)    *H10N 30/853* (2023.01)
*H10N 30/00* (2023.01)

(52) Cooperative Patent Classification (CPC):
**H10N 30/076; H10N 30/2047; H10N 30/708;
H10N 30/8542**

(54) **STACKED SUBSTRATE HAVING PIEZOELECTRIC FILM, METHOD FOR MANUFACTURING STACKED SUBSTRATE, AND PIEZOELECTRIC ELEMENT**

GESTAPELTES SUBSTRAT MIT PIEZOELEKTRISCHEM FILM, VERFAHREN ZUR HERSTELLUNG DES GESTAPELTEN SUBSTRATS UND PIEZOELEKTRISCHES ELEMENT

SUBSTRAT EMPILÉ AYANT UN FILM PIÉZOÉLECTRIQUE, PROCÉDÉ DE FABRICATION DE SUBSTRAT EMPILÉ ET ÉLÉMENT PIÉZOÉLECTRIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **27.12.2023 JP 2023220951**

(43) Date of publication of application:
**02.07.2025 Bulletin 2025/27**

(73) Proprietor: **Sumitomo Chemical Company,
Limited
Tokyo 103-6020 (JP)**

(72) Inventors:
• **TANAKA, Yasunori**
**Hitachi-shi, Ibaraki 319-1418 (JP)**
• **SHIBATA, Kenji**
**Hitachi-shi, Ibaraki 319-1418 (JP)**
• **KURODA, Toshiaki**
**Hitachi-shi, Ibaraki 319-1418 (JP)**
• **WATANABE, Kazutoshi**
**Hitachi-shi, Ibaraki 319-1418 (JP)**

(74) Representative: **Vossius & Partner
Patentanwälte Rechtsanwälte mbB
Siebertstrasse 3
81675 München (DE)**

(56) References cited:
WO-A1-2019/139100    WO-A1-2022/224594
WO-A1-2024/202319    US-A1- 2009 189 482
US-A1- 2018 287 048    US-A1- 2023 142 065

**Description**

Technical Field

The present invention relates to a stacked substrate having a piezoelectric film, a method for manufacturing a stacked substrate, and a piezoelectric element.

Description of Related Art

A piezoelectric substance is widely used in a functional electronic component such as a sensor and an actuator. Lead-based materials, particularly PZT-based ferroelectrics represented by a composition formula $Pb(Zr_{1-x}Ti_x)O_3$, are widely used the piezoelectric substance. Since PZT-based piezoelectric materials contain lead, they are undesirable from a viewpoint of preventing pollution. Therefore, piezoelectric material (KNN) containing potassium, sodium, niobium, and oxygen has been proposed as a piezoelectric material not containing lead, and a stacked substrate has been proposed having a substrate, a bottom electrode film deposited on the substrate, and a piezoelectric film deposited on the bottom electrode film using KNN (see, for example, Patent documents 1-5).

Prior art document

Patent document

   [Patent Document 1] JP 2007-184513 A
   [Patent Document 2] JP 2008-159807 A
   [Patent Document 3] US 2023/0142065 A1
   [Patent Document 4] US 2009/0189482 A1
   [Patent Document 5] WO 2022/224594 A1

Summary of the invention

Problem to be solved by the invention

An object of the present invention is to improve adhesion between a substrate and a piezoelectric film in a stacked substrate having the piezoelectric film, while suppressing a decrease in an orientation of the piezoelectric film.

Means for solving the problem

According to one embodiment of the present invention, there is provided a stacked substrate or a piezoelectric element including:

   a substrate; and
   a piezoelectric film provided on the substrate and composed of an alkali niobium oxide containing potassium, sodium, niobium, and oxygen,
   wherein SIMS analysis of a region of the substrate ranging from a surface of the substrate on which the piezoelectric film is provided to a depth of 1 $\mu$m toward a surface of the substrate opposite to the surface on which the piezoelectric film is provided, reveals that a concentration of potassium is 5E15 cm$^{-3}$ or less, and a concentration of sodium is 5E15 cm$^{-3}$ or less, and
   an orientation rate of crystals constituting the piezoelectric film in a (001) direction is 96 % or more.

According to another embodiment of the present invention, there is provided a method for manufacturing a stacked substrate, the method including:

   preparing a substrate; and
   depositing a piezoelectric film composed of an alkali niobium oxide containing potassium, sodium, niobium, and oxygen on the substrate by a sputtering method,
   wherein in the depositing the piezoelectric film, a depositing temperature is 400 °C or more and less than 500 °C, an oxygen partial pressure is 0.0025 Pa or more and less than 0.01 Pa, and an atmospheric pressure is 0.03 Pa or more and less than 0.1 Pa.

Advantage of the invention

According to the present invention, in a stacked substrate having a piezoelectric film, an adhesion between the substrate and the piezoelectric film is improved while suppressing a decrease in an orientation of the piezoelectric film.

Brief description of the drawings

FIG. 1 is a view showing an example of a cross-sectional configuration of a piezoelectric stack according to one embodiment of the present invention.

FIG. 2 is a view showing an example of a configuration of a simplified piezoelectric element according to one embodiment of the present invention.

FIG. 3 is a view showing an example of a schematic configuration of a piezoelectric element according to one embodiment of the present invention.

FIG. 4 is a view showing an example of a schematic configuration of a piezoelectric device module according to one embodiment of the present invention.

Detailed description of the invention

<One embodiment of the present invention>

Hereinafter, one embodiment of the present invention will be described with reference to the drawings.

(1) Configuration of a stacked substrate

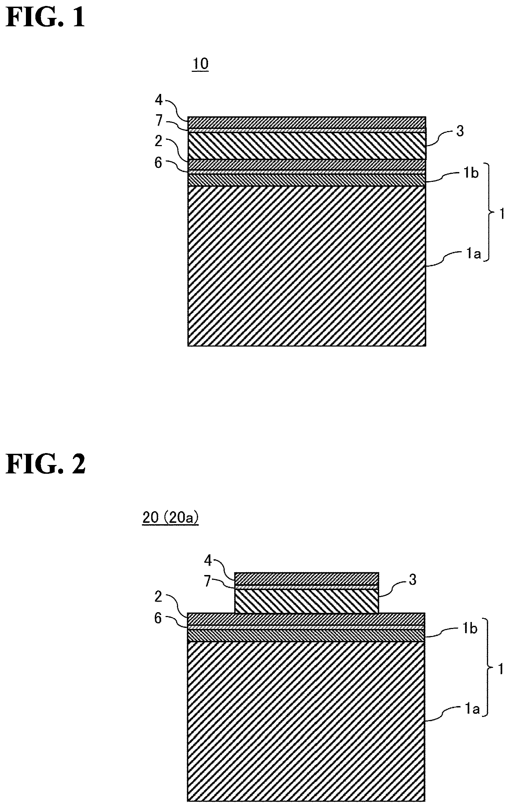

As shown in FIG. 1, a stacked substrate (stack) 10 (hereinafter also referred to as a stack 10) having a piezoelectric film according to this embodiment includes a substrate 1, a bottom electrode film 2 deposited on the substrate 1, a piezoelectric film (piezoelectric thin film) 3 deposited on the bottom electrode film 2, and a top electrode film 4 deposited on the piezoelectric film 3. The film obtained by "deposition" in the present disclosure is a film directly deposited on the substrate 1, and does not include a film attached (bonded) to the substrate 1.

The substrate 1 may be, for example, a semiconductor substrate. Specifically, as the substrate 1, a single crystal silicon (Si) substrate 1a on which a surface oxide film ($SiO_2$ film) 1b such as a thermal oxide film or a CVD (Chemical Vapor Deposition) oxide film is formed, i.e., a Si substrate having a surface oxide film, can be suitably used. Also, the substrate 1 may be a Si substrate 1a having an insulating film composed of an insulating material other than $SiO_2$, instead of the surface oxide film 1b. Also, the substrate 1 may be a Si substrate 1a having an exposed Si(100) or Si(111), that is, a Si substrate having no surface oxide film 1b or insulating film. Also, the substrate 1 may be an SOI (Silicon On Insulator) substrate or a quartz glass ($SiO_2$) substrate. The thickness of the single crystal Si substrate 1a may be, for example, 300 $\mu$m or more and 1000 $\mu$m or less, and the thickness of the surface oxide film 1b may be, for example, 1 nm or more and 4000 nm or less.

The bottom electrode film 2 may be formed using, for example, platinum (Pt). The bottom electrode film 2 is a polycrystalline film. Hereinafter, the polycrystalline film deposited using Pt is also referred to as a Pt film. It is preferable that the (111) of the Pt film is parallel to the main surface of the substrate 1 (including the case where the (111) is inclined at an angle of $\pm5°$ or less with respect to the main surface of the substrate 1), that is, the Pt film is oriented in the (111) direction. The Pt film being oriented in the (111) direction means that no peaks other than those resulting from the (111) are observed in an X-ray diffraction pattern obtained by X-ray diffraction (XRD) measured for the surface of the piezoelectric film 3. Thus, the main surface of the bottom electrode film 2 (the surface serving as the base for the piezoelectric film 3) is preferably constituted by the Pt(111). The bottom electrode film 2 can be deposited by a method such as sputtering or evaporation. As a material for the bottom electrode film 2, other than Pt, various metals such as gold (Au), ruthenium (Ru), or iridium (Ir), alloys containing these as main components, or metal oxides such as strontium ruthenium oxide ($SrRuO_3$, abbreviated as SRO) or lanthanum nickel oxide ($LaNiO_3$, abbreviated as LNO) can also be used. When the bottom electrode film 2 is deposited using a metal oxide, it is preferable that the crystals constituting the bottom electrode film 2 are preferentially oriented in the (001) direction with respect to the surface of the substrate 1. The bottom electrode film 2 may be a single layer film formed using any of the above metals, alloys containing any of the above metals as main components, metal oxides, etc. The bottom electrode film 2 may be a stack of the Pt film and a film mainly composed of SRO provided on the Pt film, or a stack of the Pt film and a film mainly composed of LNO provided on the Pt film, etc. The thickness of the bottom electrode film 2 (when the bottom electrode film 2 is a stack, the total thickness of each layer) may be, for example, 100 nm or more and 400 nm or less.

An adhesive layer 6 may be provided between the substrate 1 and the bottom electrode film 2 in order to improve adhesion therebetween. The adhesive layer 6 may be, for example, a layer (hereinafter also referred to as a "ZnO layer") containing zinc (Zn) and oxygen (O) as main components. The ZnO layer can be formed using, for example, zinc oxide. The composition ratio of Zn and O constituting the ZnO layer preferably satisfies a relationship Zn:O = 1:1, but is not limited thereto and some variation is permissible. The ZnO layer is a polycrystalline layer. It is preferable that the (0001) of the ZnO layer is parallel to the main surface of the substrate 1 (including the case where the (0001) is inclined at an angle of $\pm 5°$ or less with respect to the main surface of the substrate 1), that is, the ZnO layer is oriented in the (0001) direction. The ZnO layer being oriented in the (0001) direction means that in the X-ray diffraction pattern obtained by XRD measurement for the surface of the piezoelectric film 3, the intensity of the peak resulting from the (0002) is high. Thus, the main surface of the ZnO layer (the surface serving as the base for the bottom electrode film 2) is preferably constituted by the ZnO(0001). The ZnO layer can be deposited by a method such as sputtering or evaporation. The thickness of the ZnO layer may be, for example, 1 nm or more and 200 nm or less, preferably 10 nm or more and 50 nm or less. As the adhesive layer 6, for example, a layer mainly composed of titanium (Ti), tantalum (Ta), titanium oxide ($TiO_2$), nickel (Ni), ruthenium oxide ($RuO_2$), iridium oxide ($IrO_2$), etc., may be provided. Such an adhesive layer 6 may also be deposited by a method such as sputtering or evaporation, and the thickness of the adhesive layer 6 may be, for example, 1 nm or more and 200 nm or less, preferably 10 nm or more and 50 nm or less. In this specification, the adhesive layer 6 provided between the substrate 1 and the bottom electrode film 2 may be referred to as a bottom adhesive layer 6.

The piezoelectric film 3 is a film formed from an alkali niobium oxide containing potassium (K), sodium (Na), niobium (Nb), and oxygen (O). That is, the piezoelectric film 3 is a film mainly composed of alkali niobium oxide containing K, Na, Nb, and O. The piezoelectric film 3 may be formed using an alkali niobium oxide represented by a composition formula $(K_{1-x}Na_x)NbO_3$, that is, potassium sodium niobium oxide (KNN). The coefficient x [= Na/(K+Na)] in the above composition formula may be within a range of $0 < x < 1$, preferably $0.4 \leq x \leq 0.8$. The piezoelectric film 3 is a KNN polycrystalline film (hereinafter also referred to as a KNN film 3). Further, the crystal structure of KNN is a perovskite structure. That is, the KNN film 3 has the perovskite structure. It is preferable that more than half of the crystals in the crystal group constituting the KNN film 3 have a columnar structure. In this specification, the crystal system of KNN is considered to be a tetragonal system. The KNN film 3 may be deposited by a sputtering method. The thickness of the KNN film 3 may be, for example, 0.5 $\mu$m or more and 5 $\mu$m or less, preferably 1 $\mu$m or more and 3 $\mu$m or less.

The crystals constituting the KNN film 3 are preferentially oriented in the (001) direction with respect to the main surface of the substrate 1 (Si substrate 1a when the substrate 1 is, for example, the Si substrate 1a having the surface oxide film 1b or the insulating film, etc.). That is, the main surface of the KNN film 3 (the surface serving as the base for the top electrode film 4) is mainly composed of the KNN(001). For example, by directly depositing the KNN film 3 on the Pt film (bottom electrode film 2) whose main surface is mainly composed of the Pt(111), the KNN film 3 whose main surface is mainly composed of the KNN(001) can be obtained. In this specification, the crystals constituting the KNN film 3 being oriented in the (001) direction means that the (001) of the crystals constituting the KNN film 3 is parallel or approximately parallel to the main surface of the substrate 1. Further, the crystals constituting the KNN film 3 being preferentially oriented in the (001) direction means that there are many crystals in which the (001) is parallel or approximately parallel to the main surface of the substrate 1.

Further, the alkali niobium oxide constituting the KNN film 3 may further contain at least one element (dopant) selected from the group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). The concentration of these elements in the alkali niobium oxide can be, for example, 5 at% or less (when a plurality of the above elements are contained, the total concentration is 5 at% or less).

The top electrode film 4 is mainly composed of various metals such as Pt, Au, Al, Cu, etc., or alloys thereof. The top electrode film 4 can be deposited by a method such as sputtering, evaporation, plating, metal paste. The top electrode film 4 does not have a large effect on the crystal structure of the KNN film 3 unlike the bottom electrode film 2. Therefore, the material, crystal structure, and deposition method of the top electrode film 4 are not particularly limited. An adhesive layer 7 mainly composed of, for example, $RuO_2$, $IrO_2$, Ti, Ta, $TiO_2$, Ni, etc., may be provided between the KNN film 3 and the top electrode film 4 in order to improve adhesion therebetween. The thickness of the top electrode film 4 may be, for example, 50 nm or more and 5000 nm or less, preferably 50 nm or more and 300 nm or less. When the adhesive layer 7 is provided, the thickness of the adhesive layer 7 may be, for example, 1 nm or more and 200 nm or less, preferably 5 nm or more and 50 nm or less. In this specification, the adhesive layer 7 provided between the KNN film 3 and the top electrode film 4 may be referred to as a top adhesive layer 7.

Although the details will be described later, this embodiment shows that in the process of fabricating the stack 10, the KNN film 3 is deposited under conditions of low temperature, high oxygen partial pressure, and low atmospheric pressure. Thereby the stack 10 of this embodiment has both Features 1 and 2 described below, and the stack 10 of this embodiment may further have Feature 3 described below. Various features that the stack 10 of this embodiment may have will be described below.

(Feature 1)

During deposition of the KNN film 3, alkali metals (potassium atoms, sodium atoms) may diffuse and reach the substrate 1 through the bottom electrode film 2 (and the bottom adhesive layer 6). When the alkali metal diffuses and reaches the substrate 1, the adhesion between the substrate 1 and the bottom electrode film 2 (or a bottom adhesive layer 6, if present) may decrease in some cases. Thereby, when an excessively external force is repeatedly applied to the periphery (peripheral members) of the bottom electrode film 2 due to repeated large deformation of the KNN film 3 during drive of the piezoelectric element 20 (piezoelectric device module 30) obtained by processing the stack 10, peeling of the bottom electrode film 2 and therefore the KNN film 3 from the substrate 1 may occur.

To cope with such a problem, in this embodiment, the KNN film 3 is deposited at a low temperature in the process of fabricating the stack 10. This successfully suppresses the diffusion of alkali metals to the substrate 1 and reaching the substrate 1. Specifically, the stack 10 in this embodiment has a feature (Feature 1) such that analysis of the surface region of the substrate 1 by secondary ion mass spectrometry (SIMS) reveals that a potassium concentration (K concentration) is $5E15$ $cm^{-3}$ or less and a sodium concentration (Na concentration) is $5E15$ $cm^{-3}$ or less.

Thus, by depositing the KNN film 3 at a low temperature, the diffusion of alkali metals to the substrate 1 and reaching the substrate 1 can be suppressed, and the stack 10 having low K and Na concentrations in the surface region of the substrate 1 can be obtained. This is a novel knowledge that was first found as a result of extensive research by the present inventors.

In this specification, the "surface region of the substrate 1" refers to a region ranging from the top surface of the substrate 1 (from the top surface of the surface oxide film 1b when the substrate 1 has the surface oxide film 1b) to a depth of 1 $\mu$m in the thickness direction of the substrate 1 (toward the bottom surface of the substrate 1). Further, the "top surface of the substrate 1" refers to one of the two main surfaces of the substrate 1, which is the surface on which the bottom electrode film 2, etc., are formed, and the "bottom surface of the substrate 1" refers to one of the two main surfaces of the substrate 1, which is the surface opposite to the top surface of substrate 1.

Due to each of the K concentration and the Na concentration in the surface region of the substrate 1 being $5E15$ $cm^{-3}$ or less, the adhesion between the substrate 1 and the bottom electrode film 2 (or the bottom adhesive layer 6) can be improved. Thereby, even when an excessively large external force is repeatedly applied to the periphery of the bottom electrode film 2 during drive of the piezoelectric element 20 (piezoelectric device module 30) described below, peeling of the bottom electrode film 2 and therefore the KNN film 3 from the substrate 1 can be prevented. As a result, reliability of the piezoelectric element 20 (piezoelectric device module 30) can be improved.

The lower the K concentration and the Na concentration in the surface region of the substrate 1, the more the adhesion between the substrate 1 and the bottom electrode film 2 (or the bottom adhesive layer 6) can be improved. It is preferable that the K concentration and the Na concentration in the surface region of the substrate 1 are each $3E14$ $cm^{-3}$ or less. This enables to further improve the above-described adhesion. Further, it is more preferable that the K concentration in the surface region of the substrate 1 is, for example, $1E14$ $cm^{-3}$ or less. This enables to further improve the above-described adhesion.

The lower limits of the K concentration and the Na concentration in the surface region of the substrate 1 are not particularly limited. At present, according to SIMS analysis, the detection limit of the K concentration is about $1E14$ $cm^{-3}$, and the detection limit of the Na concentration is about $3E14$ $cm^{-3}$.

(Feature 2)

When the KNN film 3 is deposited at a low temperature, the diffusion of the alkali metals to the substrate 1 and reaching the substrate 1 can be suppressed, but the (001) orientation rate of the KNN film 3 may decrease in some cases.

To cope with such a problem, in this embodiment, the KNN film 3 is deposited under conditions of low temperature, high oxygen partial pressure, and low atmospheric pressure in the process of fabricating the stack 10. That is, the deposition conditions for the KNN film 3 are not only low temperature but also high oxygen partial pressure and low atmospheric pressure. This enables to successfully obtain the KNN film 3 having a high (001) orientation rate (high crystal orientation) even when the film is deposited at a low temperature. This is a novel knowledge that was first found as a result of extensive research by the present inventors.

Specifically, in addition to Feature 1, the stack 10 further has a feature (Feature 2) such that the (001) orientation rate of the KNN film 3 is 96 % or more, preferably 98 % or more.

The (001) orientation rate of the KNN film 3 is the orientation rate of the crystals constituting the KNN film 3 in the (001) direction. "The (001) orientation rate of the KNN film 3 is 96 % or more" means that, for example, 96 % or more of the crystals constituting the KNN film 3 are oriented in the (001) direction with respect to the main surface of the substrate 1. The "orientation rate" in this specification is a value calculated from the following formula (1) based on the peak intensity in the X-ray diffraction pattern ($2\theta/\theta$) obtained by performing XRD measurement for the KNN film 3.

Orientation rate (%) = {(001) peak intensity/((001) peak intensity+(110) peak intensity)}$\times$100 $\cdots$ (1)          (1)

The "(001) peak intensity" in the above formula (1) refers to, in the X-ray diffraction pattern obtained by performing XRD measurement for the KNN film 3, the intensity of a diffraction peak resulting from crystals oriented in the (001) direction (i.e., crystals whose (001) is parallel to the main surface of the substrate 1) among the crystals constituting the KNN film 3, which is the peak intensity appearing within the range of $2\theta$ of 20° to 23°, and which is the highest peak intensity when multiple peaks appear within the range of 20 of 20° to 23°. Also, the "(110) peak intensity" in the above formula (1) refers to, in the X-ray diffraction pattern obtained by performing XRD measurement for the KNN film 3, the intensity of a diffraction peak resulting from crystals oriented in the (110) direction (i.e., crystals whose (110) is parallel to the main surface of the substrate 1) among the crystals constituting the KNN film 3, which is the peak intensity appearing within the range of 20 of 30° to 33°, and which is the highest peak intensity when multiple peaks appear within the range of $2\theta$ of 30° to 33°.

In order to realize this feature, the KNN film 3 is required to have a perovskite structure. This is because, when the KNN film 3 does not have a perovskite structure, no peak can be observed within the range of $2\theta$ of at least 20° to 23° in the X-ray diffraction pattern obtained by performing the XRD measurement, and as a result, the (001) orientation rate cannot be calculated.

(Feature 3)

In this embodiment, in the process of fabricating the stack 10, the KNN film 3 is deposited under conditions of low temperature, high oxygen partial pressure, and low atmospheric pressure. This enables to successfully obtain the KNN film 3 having a high (001) orientation rate even when the film is deposited at a low temperature. As a result, the KNN film 3 with a high piezoelectric constant can also be obtained.

Specifically, in addition to the above Features 1 and 2, the stack 10 may further have a feature (Feature 3) such that the absolute value of the piezoelectric constant $e_{31}$ of the KNN film 3 is, for example, 7 C/m$^2$ or more, preferably 10 C/m$^2$ or more.

(2) Structure of the piezoelectric element and the piezoelectric device module

FIG. 2 shows a schematic configuration view of an element (device) 20 (element 20 having the KNN film 3, hereinafter also referred to as a piezoelectric element 20) obtained by forming the above-described stack 10 into a predetermined shape by etching, etc. In this specification, the piezoelectric element 20 shown in FIG. 2 is also referred to as a simplified piezoelectric element 20a.

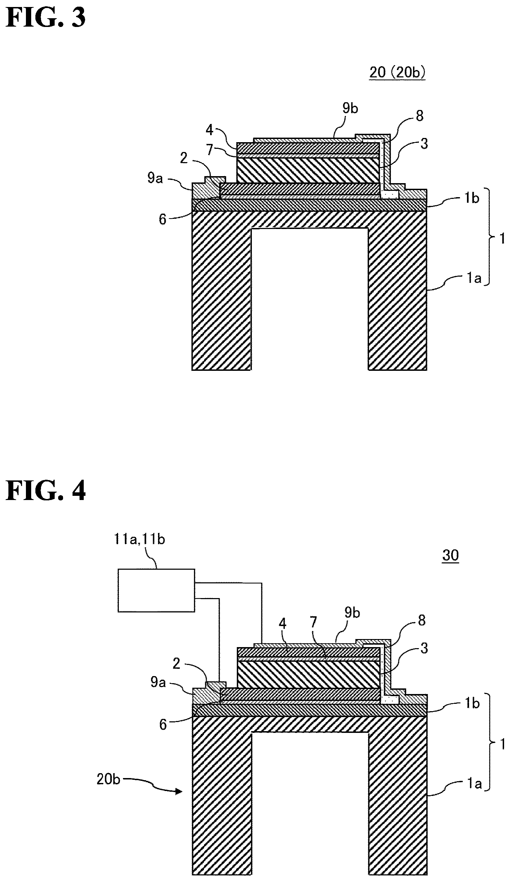

Further, the piezoelectric element 20 may have a membrane structure, a cantilever structure, etc. FIG. 3 shows a schematic configuration view of a membrane-type MEMS piezoelectric element 20b as an example of such a piezoelectric element 20, the piezoelectric element 20b being obtained by further molding the simplified piezoelectric element 20a. The piezoelectric element 20b is obtained by performing Deep-RIE or wet etching to the simplified piezoelectric element 20a to remove a part of the substrate 1 from the rear surface side of the substrate 1 (one of the two main surfaces of the substrate 1, which is the surface opposite to the surface on which the bottom electrode film 2, etc., are deposited). The piezoelectric element 20b further includes an insulating film 8 and metal wirings 9a and 9b.

The metal wiring 9a is provided so as to be connected (in contact) with the bottom electrode film 2 but not connected (in contact) with the top electrode film 4. Further, the metal wiring 9b is provided so as to be connected to the top electrode film 4 and not connected to the bottom electrode film 2. The metal wirings 9a and 9b each can be formed using various metals such as Au, Al, Ti, Cr, etc., or alloys containing these metals as main components. The metal wirings 9a and 9b may be a single-layer film or a stack in which multiple layers are stacked. The metal wirings 9a and 9b can be formed by a method such as sputtering, evaporation, plating, or metal paste.

The insulating film 8 is provided to insulate the metal wiring 9b from the bottom electrode film 2. The insulating film 8 is provided extending from the top electrode film 4 to the substrate 1 so as to cover, for example, a part of the side surface of the KNN film 3. The insulating film 8 can be formed using an oxide such as silicon oxide (SiO$_2$), aluminum oxide (Al$_2$O$_3$),

or tantalum oxide ($Ta_2O_5$). The insulating film 8 may be a single layer film or a stack in which multiple layers are stacked. The insulating film 8 can be formed by a method such as a CVD method or sputtering.

FIG. 4 shows a schematic configuration view of a device module 30 (hereinafter also referred to as a piezoelectric device module 30) having the KNN film 3 according to this embodiment. The piezoelectric device module 30 includes at least a piezoelectric element 20b shown in FIG. 3, and a voltage applicator 11a or a voltage detector 11b connected to the piezoelectric element 20b. The piezoelectric device module 30 may include the simplified piezoelectric element 20a shown in FIG. 2 instead of the piezoelectric element 20b shown in FIG. 3.

The voltage applicator 11a is a means for applying a voltage between the bottom electrode film 2 and the top electrode film 4 (between the electrodes), and the voltage detector 11b is a means for detecting a voltage generated between the bottom electrode film 2 and the top electrode film 4 (between the electrodes). The voltage applicator 11a and the voltage detector 11b may be implemented by various known means.

By connecting the voltage applicator 11a between the bottom electrode film 2 and the top electrode film 4 of the piezoelectric element 20, the piezoelectric device module 30 can function as an actuator. Application of voltage between the bottom electrode film 2 and the top electrode film 4 by the voltage applicator 11a enables to deform the KNN film 3. Due to such a deforming action, various structures connected to the piezoelectric device module 30 can be actuated. In this case, for example, the piezoelectric device module 30 can be applied to heads for inkjet printers, MEMS mirrors for scanners, and vibrators for ultrasonic generators, etc.

By connecting the voltage detector 11b between the bottom electrode film 2 and the top electrode film 4 of the piezoelectric element 20, the piezoelectric device module 30 can function as a sensor. When the KNN film 3 is deformed in accordance with a change in some physical quantity, voltage is generated between the bottom electrode film 2 and the top electrode film 4 due to the deformation. By detecting this voltage with the voltage detector 11b, the magnitude of the physical quantity applied to the KNN film 3 can be measured. In this case, for example, the piezoelectric device module 30 can be applied to an angular velocity sensor, an ultrasonic sensor, a pressure sensor, an acceleration sensor, etc.

(3) Method for manufacturing a piezoelectric stack, a piezoelectric element, and a piezoelectric device module

A method for manufacturing the above-described stack 10, piezoelectric element 20, and piezoelectric device module 30 will be described.

(Preparation of a substrate)

First, a Si substrate having a surface oxide film 1b is prepared as the substrate 1.

(Deposition of the bottom adhesive layer and the bottom electrode film)

On the surface oxide film 1b of the substrate 1, the bottom adhesive layer 6 (e.g., a ZnO layer) and the bottom electrode film 2 (e.g., a Pt film) are deposited in this order by, for example, a sputtering method. It is also acceptable to prepare the substrate 1 on which the bottom adhesive layer 6 and the bottom electrode film 2 are deposited in advance on either of the main surfaces.

The conditions for depositing the ZnO layer as the bottom adhesive layer 6 are exemplified as follows. The deposition time for the bottom adhesive layer 6 is appropriately adjusted depending on the target thickness of the bottom adhesive layer 6.

Target: ZnO sintered ceramics
Temperature (substrate temperature): 200 °C or more and 700 °C or less, preferably 300 °C or more and 700 °C or less, more preferably 500 °C or more and 700 °C or less RF power density: 2 $W/cm^2$ or more and 6 $W/cm^2$ or less, preferably 3 $W/cm^2$ or more and 5 $W/cm^2$ or less
Atmosphere: an atmosphere of a mixed gas of argon (Ar) gas and oxygen ($O_2$) gas (hereinafter also referred to as "$Ar/O_2$ mixed gas atmosphere")
Ratio of partial pressure of Ar gas to $O_2$ gas (Ar gas partial pressure/$O_2$ gas partial pressure): 5/1 to 30/1, preferably 7/1 to 20/1, more preferably 10/1 to 15/1
Atmospheric pressure: 0.1 Pa or more and 0.5 Pa or less, preferably 0.2 Pa or more and 0.4 Pa or less
Thickness: 1 nm or more and 200 nm or less, preferably 10 nm or more and 50 nm or less

In this specification, when a numerical range is expressed, such as "5/1 to 30/1", it means that a lower limit value and an upper limit value are included in the range. The same applies to other numerical value ranges. Further, in this specification, the "substrate temperature" refers to the surface temperature of the substrate 1 during the deposition of each film (each layer).

The conditions for depositing the Ti layer, etc., as the bottom adhesive layer 6 are exemplified as follows.

Target: Ti plate, etc.
Temperature (substrate temperature): 100 °C or more and 500 °C or less, preferably 200 °C or more and 400 °C or less
Atmosphere: Ar gas atmosphere
Atmospheric pressure: 0.1 Pa or more and 0.5 Pa or less, preferably 0.2 Pa or more and 0.4 Pa or less

The other conditions can be similar to those used when providing the ZnO layer.

The conditions for depositing the Pt film as the bottom electrode film 2 are exemplified as follows. The deposition time for the bottom electrode film 2 is appropriately adjusted depending on the target thickness of the bottom electrode film 2.

Target: Pt plate
Temperature (substrate temperature): 200 °C or more and 600 °C or less, preferably 300 °C or more and 500 °C or less
RF power density: 1 W/cm$^2$ or more and 5 W/cm$^2$ or less, preferably 2 W/cm$^2$ or more and 4 W/cm$^2$ or less
Atmosphere: Ar gas atmosphere
Atmospheric pressure: 0.1 Pa or more and 0.5 Pa or less, preferably 0.2 Pa or more and 0.4 Pa or less
Thickness: 100 nm or more and 400 nm or less

(Deposition of the KNN film)

After depositions of the bottom adhesive layer 6 and the bottom electrode film 2 are completed, the KNN film 3 is then deposited on the bottom electrode film 2 by a sputtering method such as RF magnetron sputtering. The composition of the KNN film 3 can be adjusted, for example, by controlling the composition of a target used during sputtering deposition. The target can be fabricated by mixing $K_2CO_3$ powder, $Na_2CO_3$ powder, $Nb_2O_5$ powder, etc., and sintering the mixture. The composition of the target can be controlled by adjusting the mixing ratio of $K_2CO_3$ powder, $Na_2CO_3$ powder, $Nb_2O_5$ powder, etc. When depositing the KNN film 3 containing the above-described elements such as Cu or Mn, the target obtained by mixing Cu powder (or CuO powder), Mn powder (or MnO powder), etc., in a predetermined ratio in addition to the above-described powders may be used.

In this embodiment, the deposition conditions for the KNN film 3 are a low temperature, a high oxygen partial pressure, and a low atmospheric pressure. Specifically, the conditions for depositing the KNN film 3 are exemplified as follows. The deposition time for the KNN film 3 is appropriately adjusted depending on the target thickness of the KNN film 3.

Temperature (substrate temperature): 400 °C or more and less than 500 °C, more preferably 400 °C or more and 450 °C or less
Atmosphere: Ar/$O_2$ mixed gas atmosphere
Oxygen partial pressure in the atmosphere ($O_2$ gas partial pressure): 0.0025 Pa or more and less than 0.01 Pa, preferably 0.003 Pa or more and less than 0.01 Pa
Atmospheric pressure (chamber pressure): 0.03 Pa or more and less than 0.1 Pa, preferably 0.03 Pa or more and less than 0.08 Pa
RF power density: 2.7 W/cm$^2$ or more and 4.1 W/cm$^2$ or less, preferably 2.8 W/cm$^2$ or more and 3.8 W/cm$^2$ or less
Deposition rate: 0.5 $\mu$m/hr or more and 4 $\mu$m/hr or less, preferably 0.5 $\mu$m/hr or more and 2 $\mu$m/hr or less
Thickness: 0.5 $\mu$m or more and 5 $\mu$m or less, preferably 1 $\mu$m or more and 3 $\mu$m or less

By depositing the KNN film 3 under the above-described conditions, particularly with the depositing temperature, oxygen partial pressure, and atmospheric pressure all falling within the ranges of the above-described specified conditions, the stack 10 in which the K concentration and the Na concentration in the surface region of the substrate 1 are each 5E15 cm$^{-3}$ or less, and the (001) orientation rate of the KNN film 3 is 96 % or more, can be obtained. That is, the stack 10 having both the above-described Features 1 and 2 can be obtained.

Particularly, by depositing the KNN film 3 at a depositing temperature within the range of the above-described specified conditions, the diffusion of alkali metals to the substrate 1 and reaching the substrate 1 can be suppressed. As a result, the K concentration and the Na concentration in the surface region of the substrate 1 can each be 5E15 cm$^{-3}$ or less. That is, the stack 10 having the above-described Feature 1 can be obtained.

When the depositing temperature for the KNN film 3 is 500 °C or more, the diffusion of the alkali metals to the substrate 1 and reaching the substrate 1 may not be suppressed.

Due to the depositing temperature for the KNN film 3 being less than 500 °C, the diffusion of the alkali metals can be suppressed, and the K concentration and the Na concentration each in the surface region of the substrate 1 can be reduced. As a result, the K concentration and the Na concentration in the surface region of the substrate 1 can each be reduced to 5E15 cm$^{-3}$ or less. Further, due to the depositing temperature for the KNN film 3 being, for example, 450 °C or less, the diffusion of the alkali metals can be reliably suppressed, and the K concentration and the Na concentration each in the surface region of the substrate 1 can be further reduced. For example, the K concentration and the Na concentration in the surface region of the substrate 1 can each be reduced to 3E14 cm$^{-3}$ or less, and further, the K concentration in the surface region of the substrate 1 can be reduced to 1E14 cm$^{-3}$ or less.

When the depositing temperature for the KNN film 3 is less than 400 °C, the (001) orientation rate of the KNN film 3 may decrease in some cases, while saturating the effect of suppressing the diffusion of the alkali metals to the substrate 1 and reaching the substrate 1. As a result, even when the oxygen partial pressure and the atmospheric pressure during the deposition of the KNN film 3 are within the range of the specified conditions, the (001) orientation rate of the KNN film 3 may not be increased to 96 % or more.

Due to the depositing temperature for the KNN film 3 being 400 °C or more, the KNN film 3 having the (001) orientation rate of 96 % or more can be reliably obtained while suppressing the diffusion of the alkali metals to the substrate 1 and reaching the substrate 1. That is, the stack 10 having both the above-described Features 1 and 2 can be obtained.

Further, when the oxygen partial pressure during the deposition of the KNN film 3 is less than 0.0025 Pa, the (001) orientation rate of the KNN film 3 may not be increased sufficiently. Accordingly, when the depositing temperature for the KNN film 3 is 400 °C or more and less than 500 °C and when the oxygen partial pressure is less than 0.0025 Pa, the (001) orientation rate of the KNN film 3 may not be increased to 96 % or more. As a result, the absolute value of the piezoelectric constant $e_{31}$ may not be 7 C/m$^2$ or more.

Due to the oxygen partial pressure being 0.0025 Pa or more, the (001) orientation rate of the KNN film 3 can be sufficiently increased, and even when the depositing temperature for the KNN film 3 is 400 °C or more and less than 500 °C, the (001) orientation rate of the KNN film 3 can be increased to 96 % or more. That is, the stack 10 having both the above-described Features 1 and 2 can be obtained. Further, due to the oxygen partial pressure being 0.0025 Pa or more, even when the depositing temperature for the KNN film 3 is 400 °C or more and less than 500 °C, the absolute value of the piezoelectric constant $e_{31}$ of the KNN film 3 can be 7 C/m$^2$ or more. That is, the stack 10 having all of the above-described Features 1 to 3 can be obtained. Due to the oxygen partial pressure being 0.003 Pa or more, the (001) orientation rate of the KNN film 3 can be further increased, and the (001) orientation rate of the KNN film 3 can be increased to 98 % or more, and also, the absolute value of the piezoelectric constant $e_{31}$ of the KNN film 3 can be increased to 10 C/m$^2$ or more.

When the oxygen partial pressure is 0.01 Pa or more, the sputtering energy required for crystallization of the KNN film 3 is taken away by ionization of oxygen, and therefore the (001) orientation rate of the KNN film 3 is likely to decrease. Accordingly, when the depositing temperature is 400 °C or more and less than 500 °C and when the oxygen partial pressure is 0.01 Pa or more, the (001) orientation rate of the KNN film 3 may not be increased to 96 % or more. As a result, the absolute value of the piezoelectric constant $e_{31}$ may not be 7 C/m$^2$ or more.

Due to the oxygen partial pressure being less than 0.01 Pa, the decrease in the (001) orientation rate of the KNN film 3 can be suppressed, and even when the depositing temperature for the KNN film 3 is 400 °C or more and less than 500 °C, the (001) orientation rate of the KNN film 3 can be increased to 96 % or more. That is, the stack 10 having both the above-described Features 1 and 2 can be obtained. Further, due to the oxygen partial pressure being less than 0.01 Pa, even when the depositing temperature for the KNN film 3 is 400 °C or more and less than 500 °C, the absolute value of the piezoelectric constant $e_{31}$ can be 7 C/m$^2$ or more.

Further, when the atmospheric pressure during the deposition of the KNN film 3 is 0.1 Pa or more, the (001) orientation rate of the KNN film 3 may not be increased sufficiently. Accordingly, when the depositing temperature for the KNN film 3 is 400 °C or more and less than 500 °C and when the atmospheric pressure is 0.1 Pa or more, the (001) orientation rate of the KNN film 3 may not be increased to 96 % or more. As a result, the absolute value of the piezoelectric constant $e_{31}$ may not be 7 C/m$^2$ or more.

Due to the atmospheric pressure being less than 0.1 Pa, the (001) orientation rate of the KNN film 3 can be sufficiently increased, and the (001) orientation rate of the KNN film 3 can be increased to 96 % or more. That is, the stack 10 having both the above-described Features 1 and 2 can be obtained. Further, due to the atmospheric pressure being less than 0.1 Pa, the absolute value of the piezoelectric constant $e_{31}$ of the KNN film 3 can be 7 C/m$^2$ or more. Further, due to the atmospheric pressure being 0.08 Pa or less, the (001) orientation rate of the KNN film 3 can be further increased, and the (001) orientation rate of the KNN film 3 can be increased to 98 % or more, and also, the absolute value of the piezoelectric constant $e_{31}$ of the KNN film 3 can be increased to 10 C/m$^2$ or more.

Further, when the atmospheric pressure is less than 0.03 Pa, the (001) orientation rate of the KNN film 3 may not be increased sufficiently. Accordingly, when the depositing temperature for the KNN film 3 is 400 °C or more and less than 500 °C and when the atmospheric pressure is less than 0.03 Pa, the (001) orientation rate of the KNN film 3 may not be increased to 96 % or more. As a result, the absolute value of the piezoelectric constant $e_{31}$ may not be 7 C/m$^2$ or more.

Due to the atmospheric pressure being 0.03 Pa or more, the (001) orientation rate of the KNN film 3 can be sufficiently increased, and even when the depositing temperature for the KNN film 3 is 400 °C or more and less than 500 °C, the (001) orientation rate of the KNN film 3 can be increased to 96 % or more. That is, the stack 10 having both the above-described Features 1 and 2 can be obtained. Further, due to the atmospheric pressure being 0.03 Pa or more, the absolute value of the piezoelectric constant $e_{31}$ of the KNN film 3 can be 7 C/m$^2$ or more.

As described above, only by depositing the KNN film 3 with the depositing temperature, oxygen partial pressure, and atmospheric pressure all falling within the ranges of the above-described specified conditions, the stack 10 having both the above-described Features 1 and 2, or further the stack 10 having all of the above-described Features 1, 2, and 3, can be obtained. If at least any one of the depositing temperature, oxygen partial pressure, and atmospheric pressure conditions is outside the above-described range, the stack having both the above-described Features 1 and 2 may not be obtained.

(Deposition of the top adhesive layer and the top electrode film)

After the deposition of the KNN film 3 is completed, the top adhesive layer 7 (e.g., a RuO$_2$ layer) and the top electrode film 4 (e.g., a Pt film) are deposited in this order on the KNN film 3 by, for example, a sputtering method.

The conditions for depositing the RuO$_2$ layer, etc., as the top adhesive layer 7 are exemplified as follows. The deposition time for the top adhesive layer 7 is appropriately adjusted depending on the target thickness of the top adhesive layer 7. Target: Ru plate, etc.

Temperature (substrate temperature): Room temperature (25 °C) or more and less than 500 °C, preferably room temperature (25 °C) or more and 450 °C or less

RF power density: 0.3 W/cm$^2$ or more and 2 W/cm$^2$ or less, preferably 0.5 W/cm$^2$ or more and 1 W/cm$^2$ or less

Atmosphere: Ar/O$_2$ mixed gas atmosphere

Ratio of Ar gas partial pressure to O$_2$ gas (Ar gas partial pressure/O$_2$ gas partial pressure): 3/5 to 1/1, preferably 3/4 to 1/1

Atmospheric pressure: 0.1 Pa or more and 1.0 Pa or less, preferably 0.2 Pa or more and 0.7 Pa or less

Thickness: 1 nm or more and 200 nm or less, preferably 5 nm or more and 50 nm or less

The conditions for depositing the Pt film, etc., as the top electrode film 4 are exemplified as follows. The deposition time for the top electrode film 4 is appropriately adjusted depending on the target thickness of the top electrode film 4. Target: The Pt plate, etc.

Temperature (substrate temperature): Room temperature (25 °C) or more and less than 500 °C, preferably room temperature (25 °C) or more and 450 °C or less

RF power density: 1 W/cm$^2$ or more and 5 W/cm$^2$ or less, preferably 2 W/cm$^2$ or more and 4 W/cm$^2$ or less

Atmosphere: Ar gas atmosphere

Atmospheric pressure: 0.1 Pa or more and 0.5 Pa or less, preferably 0.2 Pa or more and 0.4 Pa or less

Thickness: 50 nm or more and 5000 nm or less, preferably 50 nm or more and 300 nm or less

By depositing the top adhesive layer 7 and the top electrode film 4 under the above-described conditions, particularly by depositing the top adhesive layer 7 and the top electrode film 4 at a depositing temperature within the range of the above-described specified conditions, the diffusion of the alkali metals to the substrate 1 and reaching the substrate 1 can be more reliably suppressed. As a result, the stack 10 in which the K concentration and the Na concentration in the surface region of the substrate 1 are each 5E15 cm$^{-3}$ or less, can be more reliably obtained.

As described above, the bottom adhesive layer 6, the bottom electrode film 2, the KNN film 3, the top adhesive layer 7, and the top electrode film 4 are deposited in this order. Thereby, the stack 10 as shown in FIG. 1 can be obtained.

(Fabrication of the piezoelectric element)

After the stack 10 as shown in FIG. 1 is fabricated, the stack 10 is processed to fabricate a simplified piezoelectric element 20a.

Specifically, first, for example, the top electrode film 4 (including the top adhesive layer 7) and the KNN film 3 are individually patterned by dry etching using Ar gas or reactive gas. In the patterning, the top electrode film 4 (including the top adhesive layer 7) and the KNN film 3 are each formed into a predetermined shape, and a part of the bottom electrode film 2 is exposed. Further, in the patterning, a photoresist can be used as an etching mask.

After fabricating the simplified piezoelectric element 20a as shown in FIG. 2, for example, the bottom electrode film 2 and the bottom adhesive layer 6 are patterned by dry etching using Ar gas or reactive gas, and the bottom electrode film 2 and the bottom adhesive layer 6 are formed into predetermined shapes. In this patterning, a photoresist can be used as an etching mask.

After completing the patterning of the bottom electrode film 2 and the bottom adhesive layer 6, the insulating film 8 and metal wirings 9a and 9b are provided. Specifically, first, a layer composed of an insulating material (that is, the insulating film 8) is provided extending from the top electrode film 4 to the substrate 1 so as to cover the side surface of the KNN film 3 by a method such as a CVD method or sputtering. Then, the insulating film 8 is patterned by dry etching using Ar gas or reactive gas such as $CF_4$ gas, or wet etching, to form the insulating film 8 into a predetermined shape.

After the insulating film 8 is provided, a layer composed of a material containing metal (metal wiring layer) is provided by a method such as sputtering, evaporation, plating, or metal paste. Then, the metal wiring layer is patterned by dry etching using Ar gas or reactive gas, or wet etching, to thereby form metal wirings 9a and 9b. The metal wiring 9a is formed (patterned) so as to be connected to the bottom electrode film 2 and not connected to the top electrode film 4, and the metal wiring 9b is formed so as to be connected to the top electrode film 4 and not connected to the bottom electrode film 2.

The etching conditions for patterning when forming the insulating film 8 and the metal wirings 9a and 9b, and the etching conditions for the substrate 1 when processing the piezoelectric stack 10 into the piezoelectric element 20, can be general etching conditions used in a semiconductor device manufacturing process, as long as the insulation properties of the KNN film 3 are not deteriorated.

Further, a part of the substrate 1 is removed from the rear surface side of the substrate 1 by Deep-RIE or wet etching. Thereby, the piezoelectric element 20b as shown in FIG. 3 can be obtained.

(Fabrication of the piezoelectric device module)

By connecting the voltage applicator 11a or the voltage detector 11b to the obtained piezoelectric element 20 (20b), the device module 30 (hereinafter also referred to as the piezoelectric device module 30) having the KNN film 3 is obtained.

(4) Effect

According to this embodiment, one or more of the following effects can be obtained.

(a) In this embodiment, in the process of fabricating the stack 10, the KNN film 3 is deposited under conditions of a depositing temperature of 400 °C or more and less than 500 °C, an oxygen partial pressure of 0.0025 Pa or more and less than 0.01 Pa, and an atmospheric pressure of 0.03 Pa or more and less than 0.1 Pa.

By depositing the KNN film 3 at the depositing temperature of 400 °C or more and less than 500 °C, diffusion of the alkali metals to the substrate 1 and reaching the substrate 1 can be suppressed. As a result, the obtained stack 10 can have the feature (Feature 1) such that "the K concentration and the Na concentration in the surface region of the substrate 1 are each 5E15 $cm^{-3}$ or less."

Further, by depositing the KNN film 3 with the oxygen partial pressure and the atmospheric pressure falling within the above-described ranges, the KNN film 3 having a high (001) orientation rate can be obtained even when the KNN film 3 is deposited at a low temperature (400 °C or more and less than 500 °C). As a result, the obtained stack 10 can further have the feature (Feature 2) such that "the (001) orientation rate of the KNN film 3 is 96 % or more."

Thus, by depositing the KNN film 3 with the depositing temperature, oxygen partial pressure, and atmospheric pressure all falling within the ranges of the above-described specified conditions, the obtained stack 10 can have both the above-described Features 1 and 2.

When the stack 10 has the above-described Feature 1, the adhesion between the substrate 1 and the bottom electrode film 2 (bottom adhesive layer 6) can be improved. Thereby, even when an excessively external force is repeatedly applied to the periphery (peripheral members) of the bottom electrode film 2 due to repeated large deformation of the KNN film 3 during drive of the piezoelectric element 20 (piezoelectric device module 30), peeling of the bottom electrode film 2 and therefore the KNN film 3 from the substrate 1 can be prevented. As a result, the reliability of the piezoelectric element 20 and therefore the piezoelectric device module 30 can be improved.

Further, when the stack 10 has both Features 1 and 2, the stack 10 (piezoelectric element 20, piezoelectric device module 30) that is highly reliable and has excellent piezoelectric properties, can be obtained.

(b) The KNN film 3 is deposited, with the depositing temperature, oxygen partial pressure, and atmospheric pressure all falling within the ranges of the above-described specified conditions. Thereby, the KNN film 3 having a high piezoelectric constant can be obtained while depositing the KNN film 3 at a low temperature. As a result, in addition to the above Features 1 and 2, the stack 10 may have a feature (Feature 3) such that "the absolute value of the piezoelectric constant $e_{31}$ of the KNN film 3 is, for example, 7 $C/m^2$ or more". This ensures that the KNN film 3 and therefore the stack 10, have excellent piezoelectric properties.

It has also been proposed to fabricate a piezoelectric stack using a bonding technique, that is, a technique of depositing a first electrode film, a KNN film, and a second electrode film on a first substrate in that order, bonding the second substrate to the top surface of the second electrode film, and then, removing the first substrate, to thereby fabricate a piezoelectric stack. It is considered that in the piezoelectric stack fabricated by using such a bonding technique, alkali metal does not diffuse to the second substrate and reach the second substrate. In the piezoelectric stack fabricated by this technique, the second electrode film functions as a bottom electrode film, and the first electrode film functions as a top electrode film. However, the piezoelectric stack fabricated using such a bonding technique has a problem in that the adhesion between the substrate (second substrate) and the bottom electrode film (second electrode film) is very low. Further, in such a bonding technique, the number of steps required to fabricate the piezoelectric stack increases, which may lead to concerns about the complication of the fabrication process, reduced productivity, and increased cost. In contrast, according to this embodiment, the stack 10 is fabricated without using the bonding technique, and further, the diffusion of alkali metals to the substrate 1 and reaching the substrate 1 is suppressed during the fabrication process. Therefore, the adhesion between the substrate 1 and the bottom electrode film 2 (bottom adhesive layer 6) is successfully improved. Further, since the stack 10 is fabricated without using the bonding technique, the stack 10 (the piezoelectric element 20 and therefore the piezoelectric device module 30) according to this embodiment has no traces resulting from bonding. That is, in the stack 10 (the piezoelectric element 20 and therefore the piezoelectric device module 30) according to this embodiment, there are no traces of bonding at the interface between the substrate 1 and the KNN film 3, the interface between the substrate 1 and the bottom electrode film 2 (bottom adhesive layer 6, if present), or the interface between the bottom electrode film 2 and the KNN film 3. For example, the "traces resulting from bonding" are as follows: the presence (distribution) of inclusions (e.g., adhesive) used in bonding, and the presence (distribution) of impurities not resulting from the deposition process (e.g., impurities resulting from the adhesive).

(5) Variations

This embodiment can be modified like the following variations. In the explanation for the variations, the same components as those in the above aspect are denoted by the same reference numerals, and the description thereof will be omitted. The above embodiments and the following variations can be combined in any combination.

(Variation 1)

As the substrate 1, for example, a semiconductor substrate that is required to have a small thermal history can be used. Specifically, as the substrate 1, a semiconductor substrate (for example, a Si substrate) having a semiconductor element formed on one of its main surfaces can be used.

The semiconductor element may have, for example, a complementary metal oxide semiconductor (CMOS) structure that includes a p-type MOSFET and an n-type MOSFET that function complementarily. Further, a protective film such as an oxide film or a nitride film that protects the semiconductor element may be further formed on the substrate 1, and it may be acceptable to consider that the protective film is included in the semiconductor element. Various known techniques can be used to form the semiconductor element. Further, n-type and p-type regions of the semiconductor element can be formed using a technique such as thermal diffusion of dopants, or activation of ions by ion implantation and annealing.

Further, when the substrate 1 has a surface oxide film 1b or an insulating film, in this variation, the surface oxide film 1b or the insulating film is formed on the top surface of the substrate 1 (which is the surface with the semiconductor element formed thereon) but at a location other than the location where the semiconductor element is formed.

Further, in this variation, the bottom electrode film 2 is formed on the top surface of the substrate 1 at a location different from the location where the semiconductor element is formed (on the surface oxide film 1b or the insulating film when the substrate 1 has the surface oxide film 1b or the insulating film, etc.). Accordingly, the piezoelectric element 20 can be formed on the top surface of the substrate 1 at a location different from the location where the semiconductor element is formed. Further, the piezoelectric element 20 can also be formed on the semiconductor element (on the protective film). In these cases, the surface region of the substrate 1 is a region extending from the interface between the piezoelectric element 20 and the substrate 1, or the interface between the piezoelectric element 20 and the semiconductor element (protective film) to a depth of 1 $\mu$m toward the rear surface of the substrate 1.

In this variation also, in the process of fabricating the stack 10, the KNN film 3 is deposited, with all of the depositing temperature, oxygen partial pressure, and atmospheric pressure falling within the ranges of the above-described specified conditions. Thereby, the (001) orientation rate of the KNN film can be increased while suppressing the diffusion of alkali metals to the substrate 1 and reaching the substrate 1. As a result, similar effects to the above embodiment can be obtained. That is, the stack 10 having at least both of Features 1 and 2 can be obtained.

The CMOS structure formed using the above-described technique is vulnerable to heat. For example, when the n-type or p-type regions are heated, dopants may migrate, resulting in change in a dopant concentration. In this variation, since the KNN film 3 is deposited at a low temperature of 400 °C or more and less than 500 °C, the semiconductor element and the piezoelectric element can be formed on the same substrate 1 while reducing the thermal history of the semiconductor element. Further, by reducing the thermal history of the semiconductor element, shortening of the life span and deterioration of the performance of the semiconductor element can be suppressed.

Further, in this variation, the depositing temperatures for the bottom electrode film 2 and the bottom adhesive layer 6 are preferably each less than 500 °C. Specifically, it is preferable that the depositing temperature for the bottom electrode film 2 is set as, for example, 200 °C or more and less than 500 °C, preferably 300 °C or more and 450 °C or less, and when the ZnO layer is deposited as the bottom adhesive layer 6, the depositing temperature for the ZnO layer is set as, for example, 200 °C or more and less than 500 °C, preferably 300 °C or more and 450 °C or less, and more preferably 400 °C or more and 450 °C or less, and when the Ti layer, etc., is deposited as the bottom adhesive layer 6, the depositing temperature for the Ti layer, etc., is set as, for example, 100 °C or more and less than 500 °C, preferably 200 °C or more and 400 °C or less. This can reliably reduce the thermal history of the semiconductor element, and reliably prevent shortening of the life span and deterioration of the performance of the semiconductor element.

(Variation 2)

The above-described variation 1 shows the case in which the semiconductor element has a CMOS structure. However, the semiconductor element is not limited to CMOS, so long as it has an element structure that is vulnerable to heat. An element formed by using a technique of thermal diffusion or ion implantation of dopants to form an n-type or p-type region is vulnerable to heat. Accordingly, when the semiconductor element is formed using these techniques, that is, even when the semiconductor element has a region in which a p-type or n-type dopant is thermally diffused, or a region in which the dopant is ion-implanted, this embodiment can be suitably applied, and provides similar effects to the above-described embodiments and variation.

(Variation 3)

As described above, since the KNN film 3 is deposited at a low temperature of 400 °C or more and less than 500 °C, other substrate that is required to have a small thermal history, can be used as the substrate 1.

For example, as the substrate 1, a substrate on which a CMUT (Capacitive Micro-machined Ultrasound Transducer) structure is formed can also be used.

Further, for example, the substrate 1 may be a resin substrate or a glass substrate which is vulnerable to heat.

Examples of the resin substrates include: substrates composed of polyimide, polytetrafluoroethylene (PTFE), polyethylene naphthalate, polypropylene, polystyrene, polycarbonate, polysulfone, polyarylate, polyamide, polyethylene terephthalate (PET), and acrylic resin. Also, examples of the resin substrate include: a glass epoxy resin substrate, a paper phenol substrate, a paper epoxy substrate, a glass composite substrate, and a fluororesin substrate. Also, examples of the resin substrate include: a composite resin substrate containing, for example, silicon oxide particles, metal nanoparticles, inorganic oxide nanoparticles, inorganic nitride nanoparticles, metal-based or inorganic-based nanofibers or microfibers, etc., in the above-described resin substrate. The thickness of the resin substrate can be, for example, 10 $\mu$m or more and 1000 $\mu$m or less.

Even when the above-described substrate is used as the substrate 1, by depositing the KNN film 3 with the depositing temperature, oxygen partial pressure, and atmospheric pressure all falling within the ranges of the above-described specified conditions in the process of fabricating the stack 10, the KNN film 3 having a high (001) orientation rate can be deposited on the substrate 1 that is required to have a small thermal history or that is vulnerable to heat, while suppressing the diffusion of alkali metals to the substrate 1 and reaching the substrate 1. As a result, in this variation also, the stack 10 having at least both Features 1 and 2 can be obtained.

Further, when a substrate having a CMUT structure, a resin substrate that is vulnerable to heat, or a glass substrate is used as the substrate 1, the depositing temperatures of the bottom electrode film 2 and the bottom adhesive layer 6 are preferably each less than 500 °C. Specifically, it is preferable that the depositing temperature for the bottom electrode film 2 is set as, for example, 200 °C or more and less than 500 °C, preferably 300 °C or more and 450 °C or less, and when the ZnO layer is deposited as the bottom adhesive layer 6, the depositing temperature for the ZnO layer is set as, for example, 200 °C or more and less than 500 °C, preferably 300 °C or more and 450 °C or less, and more preferably 400 °C or more and 450 °C or less, and when the Ti layer, etc., is deposited as the bottom adhesive layer 6, the depositing temperature for the Ti layer, etc., is set as, for example, 100 °C or more and less than 500 °C, and preferably 200 °C or more and 400 °C or less. This can reliably reduce the thermal history of the substrate 1.

Further, a metal substrate can also be used as the substrate 1. Examples of the metal substrate include: a substrate mainly composed of platinum (Pt), gold (Au), iron (Fe), titanium (Ti), copper (Cu), molybdenum (Mo), nickel (Ni), aluminum (Al), tungsten (W), or palladium (Pd). Also, examples of the metal substrate include: a substrate composed of stainless steel (SUS), permalloy, or inconel. The thickness of the metal substrate can be, for example, 10 $\mu$m or more and 1000 $\mu$m or less. In this case also, by depositing the KNN film 3 with the depositing temperature, oxygen partial pressure, and atmospheric pressure all falling within the ranges of the above-described specified conditions in the process of fabricating the stack 10, the stack 10 having at least both of Features 1 and 2 can be obtained.

(Variation 4)

The above-described embodiments and variations show the case in which the bottom adhesive layer 6 and the bottom electrode film 2 are provided, but the present disclosure is not limited thereto. The bottom adhesive layer 6 and the bottom electrode film 2 may not be provided. That is, the KNN film 3 may be deposited directly on the substrate 1.

In this variation also, in the process of fabricating the stack 10, by depositing the KNN film 3 with the depositing temperature, oxygen partial pressure, and atmospheric pressure all falling within the ranges of the above-described specified conditions in the process of fabricating the stack 10, the (001) orientation rate of the KNN film can be increased while suppressing the diffusion of alkali metals to the substrate 1 and reaching the substrate 1. As a result, in this embodiment also, similar effects to those of the above-described embodiments and variations can be obtained. That is, the stack 10 having at least both of Features 1 and 2 can be obtained.

In this variation also, since the KNN film 3 is deposited at a low temperature of 400 °C or more and less than 500 °C, any of the substrates described in the above-described variations 1 to 3 can be used as the substrate 1.

<Other embodiments>

As described above, the embodiments and variations of the present disclosure have been explained in detail. However, the present disclosure is not limited to the above-described embodiments and variations, and various modifications are possible without departing from the spirit and scope of the present disclosure.

Further, the above-described embodiment shows the case in which the bottom adhesive layer 6 is provided between the substrate 1 and the bottom electrode film 2, and the top adhesive layer 7 is provided between the KNN film 3 and the top electrode film 4, but the present disclosure is not limited thereto. The bottom adhesive layer 6 and the top adhesive layer 7 do not need to be provided as long as necessary adhesion can be ensured.

Example

Hereinafter, experimental results that support the effects of the above-described embodiment will be described.

(Sample 1)

As the substrate, a Si substrate was prepared, having a surface with (100) orientation, a thickness of 610 $\mu$m, a diameter of 6 inches, and a thermal oxide film ($SiO_2$ film) having a thickness of 500 nm formed on its surface. Then, on this substrate (on the thermal oxide film), the ZnO layer (thickness: 25 nm) as a bottom adhesive layer, the Pt film (thickness: 200 to 300 nm) as a bottom electrode film, and the KNN film (thickness: 2 $\mu$m) as a piezoelectric film were sequentially formed, to fabricate the piezoelectric stack (sample 1). In the sample 1, the bottom adhesive layer, the bottom electrode film, and the KNN film were all deposited by RF magnetron sputtering.

The conditions for depositing the ZnO layer as the bottom adhesive layer were as follows.

Target: ZnO sintered ceramics
Substrate temperature: 500 °C
RF power density: 4 $W/cm^2$
Atmosphere: Ar/$O_2$ mixed gas atmosphere
Atmospheric pressure (chamber pressure): 0.3 Pa
Ar gas partial pressure/$O_2$ gas partial pressure: 10/1
Deposition time: 3 minutes (thickness 25nm)

The conditions for depositing the Pt film as the bottom electrode film were as follows.

Target: Pt plate
Substrate temperature: 500 °C
RF power density: 2 $W/cm^2$
Atmosphere: Ar gas atmosphere
Atmospheric pressure (chamber pressure): 0.3 Pa
Deposition time: 20 minutes (thickness 200 nm)

The conditions for depositing the KNN film were as follows.

Target: KNN sintered ceramics

RF power density: 3 W/cm$^2$

Atmosphere: Ar/O$_2$ mixed gas atmosphere

Depositing temperature: 490 °C

Oxygen partial pressure: 0.003 Pa

Atmospheric pressure (chamber pressure): 0.05 Pa

Deposition time: 120 minutes (thickness 2000 nm (2 $\mu$m))

(Samples 2 to 13)

In the samples 2 to 13, the temperature, oxygen partial pressure, and atmospheric pressure during the deposition of the KNN film were set as shown in Table 1. The other conditions were the same as those for the sample 1.

(Table 1)

| Sample No. | Temperature (°C) | Oxygen partial pressure (Pa) | Atmospheric pressure (Pa) |
|---|---|---|---|
| 1 | 490 | 0.003 | 0.05 |
| 2 | 450 | 0.003 | 0.05 |
| 3 | 400 | 0.003 | 0.05 |
| 4 | 500 | 0.003 | 0.05 |
| 5 | 390 | 0.003 | 0.05 |
| 6 | 450 | 0.009 | 0.05 |
| 7 | 450 | 0.01 | 0.05 |
| 8 | 450 | 0.0025 | 0.05 |
| 9 | 450 | 0.002 | 0.05 |
| 10 | 450 | 0.003 | 0.08 |
| 11 | 450 | 0.003 | 0.1 |
| 12 | 450 | 0.003 | 0.03 |
| 13 | 450 | 0.003 | 0.025 |

[Evaluation]

For each of the samples 1 to 13, the K concentration and the Na concentration in the surface region of the substrate, the (001) orientation rate of the KNN film, the piezoelectric constant $e_{31}$, and the adhesion between the substrate and the bottom adhesive layer (bottom electrode film) were evaluated.

(Measurement of the K and Na concentrations)

The K concentration and the Na concentration in the surface region of the substrate were measured by SIMS analysis. In order to improve analytical accuracy, the SIMS analysis was performed using each sample in a state where the KNN film had been removed by etching. The measurement results of the K concentration and the Na concentration in the surface region of the substrate are shown in Table 2 below. In Table 2, the K concentration of 1E14 cm$^{-3}$ or less means that the K concentration in the surface region of the substrate is equal to or less than the lower detection limit of the SIMS analysis, and the Na concentration of 3E14 cm$^{-3}$ or less means that the Na concentration in the surface region of the substrate is equal to or less than the lower detection limit of the SIMS analysis.

(Evaluation of the (001) orientation rate of the KNN film)

The (001) orientation rate of the KNN film was evaluated by calculating from the above formula (1) based on the peak intensity of the X-ray diffraction pattern ($2\theta/\theta$) obtained by performing XRD measurement for the KNN film. The calculation results of the (001) orientation rate are shown in Table 2 below. The "orientation rate" in Table 2 means the (001) orientation rate of the KNN film.

(Evaluation of the piezoelectric constant)

The piezoelectric constant $e_{31}$ of the KNN film was measured (evaluated) as follows. First, a rectangular test piece measuring 2.5 mm wide and 20 mm long was fabricated from each sample. A simple piezoelectric element having a cantilever (cantilever beam) structure was fabricated, with one end of each test piece in a longitudinal direction fixed set as a fixed end, and the other end set as a free end, and a voltage applicator was connected to this piezoelectric element. Then, the amount of displacement of the free end of the test piece was measured by a laser, while applying a voltage to the KNN film of each test piece (piezoelectric element). Then, the piezoelectric constant $e_{31}$ was calculated according to the following (equation 2) using the measured displacement. In the following (equation 2), $s_{11,s}$ is the Young's modulus of the substrate (Si substrate) of each sample, $h_s$ is the thickness of the substrate of each sample, L is a beam length (14.5 mm), $\delta$ is an output displacement based on the measured displacement amount, and V is the voltage applied to the piezoelectric film. The frequency of the AC electric field (AC voltage) when measuring the piezoelectric constant $e_{31}$ is 350 Hz, and the maximum value of the voltage applied to the KNN film is 20 V. The unit of the piezoelectric constant $e_{31}$ is C/m$^2$. The measurement results of the piezoelectric constant $e_{31}$ are shown in Table 2 below.

$$\text{(Equation 2)}$$

$$e_{31} \cong -\frac{h_s^2}{3s_{11,s}L^2}\frac{\delta}{V}$$

(Evaluation of the adhesion)

The adhesion between the substrate and the bottom adhesive layer (bottom electrode film) was evaluated by the following AC voltage application test. First, two rectangular test pieces measuring 2.5 mm wide and 20 mm long were fabricated from each sample. A simple piezoelectric element with a cantilever (cantilever beam) structure was fabricated, with one end of each test piece in the longitudinal direction fixed set as a fixed end, and the other end set as a free end, and a voltage applicator was connected to this piezoelectric element. Then, an AC voltage was continuously applied to the KNN film of the test piece (piezoelectric element) for 100 hours to one of the two pieces and for 200 hours to the other. The frequency of the AC voltage was 350 Hz, and the maximum value of the voltage applied to the KNN film was 30 V. After the voltage was applied, the presence or absence of peeling of the bottom adhesive layer (bottom electrode film) was observed by a scanning electron microscope. The evaluation results are shown in Table 2 below. In Table 2, "○" means that peeling of the bottom electrode film was not observed (no peeling occurred) in the piezoelectric element to which an AC voltage was applied for 200 hours, and "△" means that peeling of the bottom electrode film was not observed in the piezoelectric element to which the AC voltage was applied for 100 hours but peeling of the bottom electrode film was observed in the piezoelectric element to which the AC voltage was applied for 200 hours, and "×" means that peeling of the bottom electrode film was observed in the piezoelectric element to which the AC voltage was applied for 100 hours.

(Table 2)

| Sample No. | K concentration (cm$^{-3}$) | Na concentration (cm$^{-3}$) | **Orientation** rate (%) | Piezoelectric constant (C/m$^2$) | Adhesion |
|---|---|---|---|---|---|
| 1 | 5E15 | 5E15 | 100 | 7.8 | △ |
| 2 | 1E14 or less | 3E141E14 or less | 100 | 7.3 | ○ |
| 3 | 1E14 or less | 3E141E14 or less | 96 | 7.0 | ○ |
| 4 | 7E15 | 7E15 | 100 | 8.0 | × |
| 5 | 1E14 or less | 3E141E14 or less | 95 | 7.0 | ○ |
| 6 | 1E14 or less | 3E141E14 or less | 97 | 7.0 | ○ |

(continued)

| Sample No. | K concentration (cm$^{-3}$) | Na concentration (cm$^{-3}$) | **Orientation** rate (%) | Piezoelectric constant (C/m$^2$) | Adhesion |
|---|---|---|---|---|---|
| 7 | 1E14 or less | 3E141E14 or less | 94 | 6.9 | ○ |
| 8 | 1E14 or less | 3E141E14 or less | 96 | 7.0 | ○ |
| 9 | 1E14 or less | 3E141E14 or less | 94 | 6.8 | ○ |
| 10 | 1E14 or less | 3E141E14 or less | 98 | 7.5 | ○ |
| 11 | 1E14 or less | 3E141E14 or less | 95 | 6.6 | ○ |
| 12 | 1E14 or less | 3E141E14 or less | 96 | 7.0 | ○ |
| 13 | 1E14 or less | 3E141E14 or less | 95 | 6.8 | ○ |

From Table 2, it is confirmed that in the samples 1, 2, 3, 6, 8, 10, and 12 in which the KNN film was deposited under the conditions of a depositing temperature of 400 °C or more and less than 500 °C, oxygen partial pressure of 0.0025 Pa or more and less than 0.01 Pa, and atmospheric pressure of 0.03 Pa or more and less than 0.1 Pa, the K concentration and the Na concentration in the surface region of the substrate are each 5E15 cm$^{-3}$ or less, and the (001) orientation rate of the KNN film is 96 % or more. This shows that in the samples 1, 2, 3, 6, 8, 10, and 12, the diffusion of alkali metals to the substrate and reaching the substrate is suppressed, and the (001) orientation rate of the KNN film is sufficiently increased even when the KNN film is deposited at a low temperature. Further, it is also confirmed that in the samples 1, 2, 3, 6, 8, 10, and 12, the piezoelectric constant $e_{31}$ is 7 C/m$^2$ or more. Thus, it is confirmed that in the samples in which the KNN film was deposited with the depositing temperature, oxygen partial pressure, and atmospheric pressure all falling within the ranges of the above-described specified conditions, the stack having both the above-described Features 1 and 2, and further the stack having all of the above-described Features 1 to 3, can be obtained.

It is also confirmed that in the samples 2, 3, 6, 8, 10, and 12 in which the depositing temperature was 400 °C or more and 450 °C or less among the samples (stacks) having both the above-described Features 1 and 2, the K concentration and the Na concentration in the surface region of the substrate are each 3E14 cm$^{-3}$ or less, and further, the K concentration in the surface region of the substrate is 1E14 cm$^{-3}$ or less. That is, it is found that when the KNN film is deposited under the condition of 400 °C or more and 450 °C or less, the diffusion of alkali metals to the substrate and reaching the substrate is more reliably suppressed while avoiding the decrease in the (001) orientation rate of the KNN film, and the K concentration and the Na concentration can be reduced to values below the detection limit of the lower limit by the SIMS analysis. Further, in these samples, even when the AC voltage having a frequency of 350 Hz and a maximum voltage value of 30 V was applied for 200 hours, no peeling of the bottom electrode film was observed. That is, the samples 2, 3, 6, 8, 10, and 12 were found to have higher adhesion than the sample 1.

From Table 2, it is also confirmed that in the sample 4, the K concentration and the Na concentration in the surface region of the substrate are each more than 5E15 cm$^{-3}$. This shows that when the depositing temperature of the KNN film is 500 °C (500 °C or more), even when the oxygen partial pressure and the atmospheric pressure during the deposition of the KNN film are within the specified condition ranges, the diffusion of alkali metals to the substrate and reaching the substrate cannot be suppressed. That is, it is found that the stack having both the above-described Features 1 and 2 cannot be obtained.

From Table 2, it is also confirmed that in the sample 5, the (001) orientation rate of the KNN film is less than 96 %. This shows that when the depositing temperature of the KNN film is 390 °C (less than 400 °C), even when the oxygen partial pressure and the atmospheric pressure during the deposition of the KNN film are within the range of the specified conditions, the (001) orientation rate of the KNN film cannot be sufficiently increased. That is, it is found that the stack having both the above-described Features 1 and 2 cannot be obtained.

From Table 2, it is also confirmed that in the samples 7 and 9, the (001) orientation rate of the KNN film is less than 96 %, and the piezoelectric constant $e_{31}$ is less than 7.0 C/m$^2$. This shows that when the oxygen partial pressure during the deposition of the KNN film is 0.01 Pa (0.01 Pa or more) or the oxygen partial pressure during the deposition of the KNN film is 0.002 Pa (less than 0.0025 Pa), the (001) orientation rate of the KNN film cannot be sufficiently increased. Therefore, it is found that when the depositing temperature of the KNN film is less than 500 °C, the (001) orientation rate of the KNN film is less than 96 %. That is, it is found that the stack having both the above-described Features 1 and 2 cannot be obtained. It is also found that the piezoelectric constant $e_{31}$ is less than 7.0 C/m$^2$ as a result of the (001) orientation rate of the KNN film being less than 96 %.

From Table 2, it is also confirmed that in the samples 11 and 13, the (001) orientation rate of the KNN film was less than 96 %, and the piezoelectric constant $e_{31}$ was less than 7.0 C/m$^2$. This shows that when the atmospheric pressure during the deposition of the KNN film is 0.1 Pa (0.1 Pa or more) or the atmospheric pressure during the deposition of the KNN film is 0.025 Pa (less than 0.03 Pa), the (001) orientation rate of the KNN film cannot be sufficiently increased. Therefore, it is found that when the depositing temperature of the KNN film is less than 500 °C, the (001) orientation rate of the KNN film is less than 96 %. That is, it is found that the stack having both the above-described Features 1 and 2 cannot be obtained. It is also found that the piezoelectric constant $e_{31}$ can also be less than 7.0 C/m$^2$ as a result of the (001) orientation rate of the KNN film being less than 96 %.

Description of signs and numerals

    1. Substrate
    2. Bottom electrode film
    3. Piezoelectric film
    4. Top electrode film
    6. Bottom adhesive layer
    7. Top adhesive layer
    8. Insulating film
    9a, 9b. Metal wiring
    10. Stack
    20. Piezoelectric element
    30. Piezoelectric device module

**Claims**

1. A stacked substrate (10) comprising:

    a substrate (1); and
    a piezoelectric film (3) provided on the substrate and composed of an alkali niobium oxide containing potassium, sodium, niobium, and oxygen,
    wherein an orientation rate of crystals constituting the piezoelectric film in a (001) direction is 96% or more, and **characterised in that** SIMS analysis of a region of the substrate ranging from a surface of the substrate on which the piezoelectric film is provided to a depth of 1 μm toward a surface of the substrate opposite to the surface on which the piezoelectric film is provided, reveals that a concentration of potassium is 5E15 cm$^{-3}$ or less, and a concentration of sodium is 5E15 cm$^{-3}$ or less.

2. The stacked substrate according to claim 1, wherein the piezoelectric film has a piezoelectric constant $e_{31}$ of 7 C/m$^2$ or more.

3. The stacked substrate according to claim 1 or 2, wherein the substrate is any one of a semiconductor substrate, a resin substrate, a glass substrate, and a metal substrate.

4. The stacked substrate according to claim 1 or 2, wherein the substrate is a silicon substrate, and has a semiconductor element on the substrate.

5. The stacked substrate according to claim 4, wherein the substrate has a protective film that protects the semiconductor element.

6. A method for manufacturing a stacked substrate (10), the method comprising:

    preparing a substrate (1); and
    depositing a piezoelectric film (3) composed of an alkali niobium oxide containing potassium, sodium, niobium, and oxygen on the substrate by a sputtering method,
    **characterised in that** while depositing the piezoelectric film, a depositing temperature is 400 °C or more and less than 500 °C, an oxygen partial pressure is 0.0025 Pa or more and less than 0.01 Pa, and an atmospheric pressure is 0.03 Pa or more and less than 0.1 Pa.

7. A piezoelectric element (20) comprising a stacked substrate (10) according to claim 1.

**Patentansprüche**

1. Ein gestapeltes Substrat (10), umfassend:

ein Substrat (1); und
einen auf dem Substrat bereitgestellten piezoelektrischen Film (3), der aus einem Alkali-Niob-Oxid besteht, das Kalium, Natrium, Niob und Sauerstoff enthält,
wobei eine Orientierungsrate von Kristallen, die den piezoelektrischen Film bilden, in einer (001)-Richtung 96% oder mehr beträgt, und **dadurch gekennzeichnet, dass** eine SIMS-Analyse eines Bereichs des Substrats, der von einer Oberfläche des Substrats, auf der der piezoelektrische Film bereitgestellt ist, bis zu einer Tiefe von 1 $\mu$m hin zu einer Oberfläche des Substrats, die der Oberfläche, auf der der piezoelektrische Film bereitgestellt ist, gegenüberliegt, reicht, zeigt, dass eine Kaliumkonzentration 5E15 cm$^{-3}$ oder weniger beträgt und eine Natrium-konzentration 5E15 cm$^{-3}$ oder weniger beträgt.

2. Das gestapelte Substrat nach Anspruch 1, wobei der piezoelektrische Film eine piezoelektrische Konstante $e_{31}$ von 7 C/m$^2$ oder mehr aufweist.

3. Das gestapelte Substrat nach Anspruch 1 oder 2, wobei das Substrat eines aus einem Halbleitersubstrat, einem Harzsubstrat, einem Glassubstrat und einem Metallsubstrat ist.

4. Das gestapelte Substrat nach Anspruch 1 oder 2, wobei das Substrat ein Siliciumsubstrat ist und ein Halbleiterelement auf dem Substrat aufweist.

5. Das gestapelte Substrat nach Anspruch 4, wobei das Substrat einen Schutzfilm aufweist, der das Halbleiterelement schützt.

6. Ein Verfahren zur Herstellung eines gestapelten Substrats (10), wobei das Verfahren umfasst:

Herstellen eines Substrats (1); und
Abscheiden eines piezoelektrischen Films (3), der aus einem Alkali-Niob-Oxid besteht, das Kalium, Natrium, Niob und Sauerstoff enthält, auf dem Substrat mittels eines Sputterverfahrens,
**dadurch gekennzeichnet, dass** während des Abscheidens des piezoelektrischen Films eine Abscheidetemperatur 400°C oder mehr und weniger als 500°C beträgt, ein Sauerstoffpartialdruck 0,0025 Pa oder mehr und weniger als 0,01 Pa beträgt und ein Atmosphärendruck 0,03 Pa oder mehr und weniger als 0,1 Pa beträgt.

7. Ein piezoelektrisches Element (20), umfassend ein gestapeltes Substrat (10) nach Anspruch 1.

**Revendications**

1. Substrat empilé (10) comprenant :

un substrat (1) ; et
un film piézoélectrique (3) disposé sur le substrat et composé d'un oxyde de niobium alcalin contenant du potassium, du sodium, du niobium et de l'oxygène,
dans lequel le taux d'orientation des cristaux constituant le film piézoélectrique dans la direction (001) est de 96 % ou plus, et **caractérisé en ce qu'**une analyse SIMS d'une région du substrat allant d'une surface du substrat sur laquelle le film piézoélectrique est disposé jusqu'à une profondeur de 1 $\mu$m en direction d'une surface du substrat opposée à la surface sur laquelle le film piézoélectrique est disposé, révèle que la concentration de potassium est de 5E15 cm$^{-3}$ ou moins, et que la concentration de sodium est de 5E15 cm$^{-3}$ ou moins.

2. Substrat empilé selon la revendication 1, dans lequel le film piézoélectrique a une constante piézoélectrique $e_{31}$ de 7 C/m$^2$ ou plus.

3. Substrat empilé selon la revendication 1 ou 2, dans lequel le substrat est l'un quelconque parmi un substrat de semi-conducteur, un substrat de résine, un substrat de verre, et un substrat de métal.

4. Substrat empilé selon la revendication 1 ou 2, dans lequel le substrat est un substrat de silicium, et a un élément semi-conducteur sur le substrat.

5. Substrat empilé selon la revendication 4, dans lequel le substrat a un film protecteur qui protège l'élément semi-conducteur.

6. Méthode pour fabriquer un substrat empilé (10), la méthode comprenant :

la préparation d'un substrat (1) ; et
le dépôt sur le substrat d'un film piézoélectrique (3) composé d'un oxyde de niobium alcalin contenant du potassium, du sodium, du niobium et de l'oxygène, au moyen d'une méthode de pulvérisation cathodique, **caractérisée en ce que**, lors du dépôt du film piézoélectrique, la température de dépôt est de 400 °C ou plus et inférieure à 500 °C, la pression partielle d'oxygène est de 0,0025 Pa ou plus et inférieure à 0,01 Pa, et la pression atmosphérique est de 0,03 Pa ou plus et inférieure à 0,1 Pa.

7. Elément piézoélectrique (20) comprenant un substrat empilé (10) selon la revendication 1.

**FIG. 1**

10

4
7
2
6

3

1b
1

1a

**FIG. 2**

20 (20a)

4
7

2
6

3

1b
1

1a

**FIG. 3**

**FIG. 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007184513 A
- JP 2008159807 A
- US 20230142065 A1
- US 20090189482 A1
- WO 2022224594 A1